# EUROPEAN PATENT SPECIFICATION

(11) **EP 3 130 209 B1**
(45) Date of publication and mention of the grant of the patent: **24.11.2021**
(21) Application number: 14888682.3
(22) Date of filing: 11.04.2014
(51) Int. Cl.: H05K 7/20, G06F 1/20

(54) **LIQUID COOLANT SUPPLY**
FLÜSSIGKÜHLMITTELVERSORGUNG
ALIMENTATION EN LIQUIDE DE REFROIDISSEMENT

(43) Date of publication of application: 15.02.2017
(73) Proprietor: Hewlett Packard Enterprise Development LP, Houston, TX 77070 (US)
(72) Inventor: FRANZ, John, Houston, Texas 77070 (US); CADER, Tahir, Palo Alto, California 94304 (US); BASH, Cullen E,, Palo Alto, California 94304 (US); KUMARI, Niru, Palo Alto, California 94304 (US); ANTHONY, Sarah, Palo Alto, California 94304 (US); ESCOBAR-VARGAS, Sergio, Palo Alto, California 94304 (US); TAVALLAEI, Siamak, Houston, Texas 77070 (US)
(74) Representative: Iqbal, Md Mash-Hud
(86) International application number: PCT/US2014/033756
(87) International publication number: WO 2015/156817

(56) References cited:
- EP-A2- 2 640 176
- JP-A- 2005 326 141
- JP-A- 2012 054 499
- US-A- 5 761 043
- US-A1- 2001 036 061
- US-A1- 2004 008 483
- US-A1- 2006 065 874
- US-A1- 2007 221 366
- US-A1- 2007 274 043
- US-A1- 2008 007 913
- US-A1- 2009 213 541
- US-A1- 2010 300 652
- US-A1- 2012 147 553
- US-A1- 2013 146 273
- US-B2- 7 675 748

## Description

### BACKGROUND

Cooling electronics in data centers often constrains the amount of processing that can be achieved in the data center. This is because devices may be damaged if they overheat. Thus, heat is typically siphoned away from electronic devices via a combination of air conditioning, fans, and heat sinks. This may create a tradeoff because as processing increases and more power is used, more cooling may be needed. JP 2012 054499 describes a server cooling system including cooling pumps respectively provided on outer surfaces of multiple servers, and coolant is supplied to a heat generating part of each server by the cooling pump. US 2013/146273 describes a sealable module, cooled electronic system and method relating to cooling a heat generating electronic device. US 2007/274043 describes hybrid-cooled electronics chassis and boards. US 2006/065874 describes an isolation valve assembly, a coolant connect/disconnect assembly, a cooled multiblade electronics center, and methods of fabrication thereof employing an isolation valve and actuation mechanism. US 2008/007913 describes a card cage configured to hold a set of electronics cards comprising a set of walls having an input and an output and a set of flow paths formed in the set of walls to enable a fluid to flow therein. US 2012/147553 describes a system for cooling a computer server including a plurality of server modules. US 2010/300652 describes a heat dissipating system including an electronic device, a refrigeration device, a thermal connector, a cold plate, and a pipe. US 5761043 describes a daughter card assembly which provides relatively high conductive heat transfer from the electronic components on the daughter board to either an air or liquid cooled cold plate of a computer circuit module. EP 2640176 describes a cold plate device and method for cooling electronic systems including a generally flat thermally conductive body, having a cooling channel within the thermally conductive body. US 7675748 describes a disk array system including a plurality of disk drives and at least one unit box including the plurality of disk drives aligned in the thickness direction of the disk drive.

### BRIEF DESCRIPTION OF THE DRAWINGS

The present application may be more fully appreciated in connection with the following detailed description taken in conjunction with the accompanying drawings.
Fig. 1 illustrates an example computing cartridge associated with liquid coolant supply.
Fig. 2 illustrates another example computing cartridge associated with liquid coolant supply.
FIG. 3 illustrates an example chassis associated with liquid coolant supply.
FIG. 4 illustrates another example chassis associated with liquid coolant supply.
FIG. 5 illustrates another example chassis associated with liquid coolant supply.
FIG. 6 illustrates an example rack system associated with liquid coolant supply.

### DETAILED DESCRIPTION

According to a first aspect, there is provided a computing cartridge as recited in claim 1. Apparatuses associated with liquid coolant supply are described. In various examples, processors and other heat generating components on a computing cartridge may be connected via a thermal couple to a liquid cooled cold plate. The cold plate is inlaid with channels through which a liquid coolant may flow to facilitate heat transfer away from the heat generating components. The cartridge also includes fluid connectors to supply liquid coolant to the cold plate and to return heated coolant from the cold plate. Additionally, to incorporate liquid cooling into cartridges, chassis in which the cartridges are seated may also be configured with fluid connectors and corresponding fluid supply and return manifolds. To ensure supply of liquid coolant to chassis that facilitate supply of liquid coolant to its cartridges, a rack that facilitates supply of liquid coolant to the chassis is also disclosed. Fluid connectors described above operate via blind mating, and are hot plug capable to allow manipulation of a cartridge while other cartridges are operating.

It is appreciated that, in the following description, numerous specific details are set forth to provide a thorough understanding of the examples. However, it is appreciated that the examples may be practiced without limitation to these specific details. In other instances, well-known methods and structures may not be described in detail to avoid unnecessarily obscuring the description of the examples. Also, the examples may be used in combination with each other.

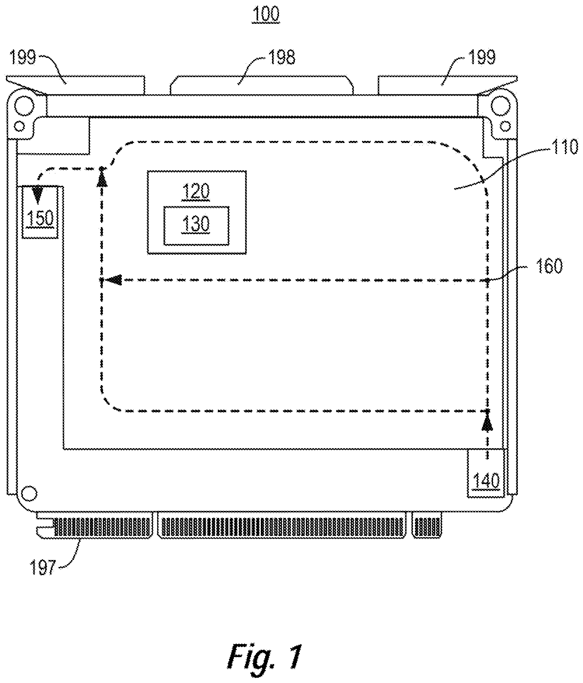

Figure 1 illustrates an example computing cartridge 100 associated with liquid coolant supply. As illustrated, cartridge 100 is a top-loading computing cartridge that fits into a slot configured to receive cartridge 100 from above. The slot may reside within a chassis. Alternative configurations that allow cartridge 100 to be inserted into a chassis and/or into a rack from other directions (e.g., the front) may also be possible in examples useful for understanding the present invention.

Cartridge 100 includes a liquid cooled cold plate 110. Cartridge 100 also includes a first electronic device 120. First electronic device may be, for example, a processor, a graphical processing unit, memory (e.g., DRAM), systems on chip (SOC), system in package (SIP), and so forth. Cartridge 100 also includes a first thermal couple 130 between first electronic device 120 and cold plate 110. Thermal couple 130 may be, for example, a physical contact between first electronic device 120 and cold plate 110, thermal paste, a heat sink, and so forth. In Figure 1, a single cold plate 110 is illustrated essentially on top of first electronic device 120 such that first electronic device 120 is sandwiched between cold plate 110 and a plane of cartridge 100 to which first electronic device 120 is electronically attached. Other configurations are also possible, for example, where cartridge 100 has two cold plates that sandwich first electronic device 120.

Cartridge 100 also includes an inlet fluid connector 140. Inlet fluid connector 140 is hot-plug capable. Conventionally, a connector is considered hot plug capable if initiating or breaking a connection does not cause a disruption to other system components. Inlet fluid connector 140 is also configured to operate via a blind mate. As used herein, a blind mate connector is a connector that automatically aligns itself to a corresponding connector when connection between the blind mate connector and the corresponding connector is initiated. Blind mate connectors may be used when it is difficult to feel or see that connectors are properly aligned. Thus, when cartridge 100 is inserted into a slot adapted to house cartridge 100, inlet fluid connector may automatically align itself with a corresponding blind mate fluid connector in the slot to ensure an effective connection between these two connectors. Inlet fluid connector 140 facilitates supply of a liquid coolant to the cold plate 110. The liquid coolant may be, for example, water, dielectric fluid, refrigerant, and so forth.

Cartridge 100 also includes an outlet fluid connector 150. Outlet fluid connector is also hot-plug capable and configured to operate via a blind mate. Outlet fluid connector 150 facilitates return of the liquid coolant from the cold plate. In this example, inlet fluid connector 140 is attached to cold plate 110 at a first corner, and outlet fluid connector 150 is attached to cold plate 110 at a second corner, the first and second corners being diagonally opposite one another on cold plate 110. However, other configurations of inlet fluid connector 140 and outlet fluid connector 150 relative to one another on cold plate 110 are possible in examples useful for understanding the present invention.

In this example, liquid coolant may flow from inlet fluid connector 140 to outlet fluid connector 150 through cold plate 110. Here, flow paths 160 illustrate one possible path of liquid coolant flow through cold plate 110. Other flow paths are possible, and may depend on the placement of inlet fluid connector 140 and outlet fluid connector 150 relative to one another. By way of illustration, in figure 1, inlet fluid connector 140 and outlet fluid connector 150 are illustrated as being at diagonally opposite corners of cold plate 110. In this example, flow paths 160 illustrate that liquid coolant generally flows up and to the left within cold plate 110 as illustrated. However, different flow paths may be appropriate if inlet fluid connector 140 and outlet fluid connector 150 reside in the same corner of cold plate 110 (e.g., the lower right corner of cold plate 110) in an example useful for understanding the present invention, at horizontally or vertically opposite corners of cold plate 110 in examples useful for understanding the present invention, or at other locations on cold plate 110.

Additionally, as illustrated, flow paths 160 are intended to show a general path a liquid coolant may take through cold plate 110 for the configuration of inlet fluid connector 140 and outlet fluid connector 150 as illustrated in this example. Thus, though fluid channels may be embedded within cold plate 110 along illustrated flow paths 160, alternative fluid channels may also be embedded. For example, though flow paths 160 are shown as going around first electronic device 120, it may be possible to achieve improved heat transfer from first electronic device 120 to the liquid coolant if fluid channels are embedded within cold plate 110 over first electronic device 120 and/or first thermal couple 130. Further, in an example useful for understanding the present invention, flow path 160 may be achieved via a hollow cavity within cold plate 110 through which liquid coolant flows, rather than channels embedded within cold plate 110. The viability a hollow cavity may depend on the relative positions of inlet fluid connector 140 and outlet connector 150 to one another on cold plate 110.

Cartridge 100 also includes latches 199 to facilitate securing cartridge 100 to a chassis in which cartridge 100 resides. Cartridge 100 also includes electronic connectors 197 which may connect to corresponding electronic connectors within the chassis. Electronic connectors 197 may facilitate communication between electronic devices residing on cartridge 100 (e.g., first electronic device 120) and other devices external to cartridge 100. These may include other devices within the chassis within which cartridge 100 resides, other devices within a rack within which cartridge 100 resides, other devices connected to a network (e.g., the Internet)to which cartridge 100 is connected, and so forth. Cartridge 100 also includes an interface 198 which may display information regarding the status (e.g., on, off, health information) of components (e.g., first electronic device 120) of cartridge 100. Interface 198 may also include, for example, buttons (e.g., power on, power off) to control operation of components of cartridge 100. Cartridge 100 may also include additional components including circuits, connectors, chipsets, and so forth (not shown) to support functionality of first electronic device 120, and/or other components on electronic device 120.

Using liquid coolants to cool electronic devices may allow more electronic devices to operate within a single cartridge, chassis, and/or rack. By way of illustration, air cooling a rack using some conventional techniques may use 100 cubic feet per minute (CFM) of air to cool 1 kilowatt (kW) of power consumed by the rack. Thus, a rack consuming 60 kW may require 6000 CFM of air to cool the rack. If a data center can deliver 800-1000 CFM of air flow across the approximate area that the space of a rack takes up, the space of 6-7 racks may be required to cool a 60 kW rack using only air cooling. If only one eighth of the space in a data center is usable for racks, air cooling may be space inefficient, thereby increasing the costs of building a data center. On the other hand, using liquid coolants may reduce the amount of power that is siphoned off via air cooling to as little as 20% to 30% or lower. Thus for the 60 kW rack reduced to 20% air cooling, only 1200 CFM of air may be necessary, thereby saving data center space.

This level of cooling via liquid cooling may be achieved because, for example, cooling electronic devices using water may achieve a thermal resistance of 0.1 centigrade/watt. Thus, even a cartridge outputting up to 250 watts of power may only increase water temperature 25 degrees, which may even allow room temperature or above (e.g., 30° centigrade) fluids to be used as liquid coolants. In fact, temperature rise of the water may be even lower because power consumption, and therefore temperature rise, may be spread out over face the cartridge, which may cause heat to transfer to water flowing along different flow paths 160 across cartridge 100.

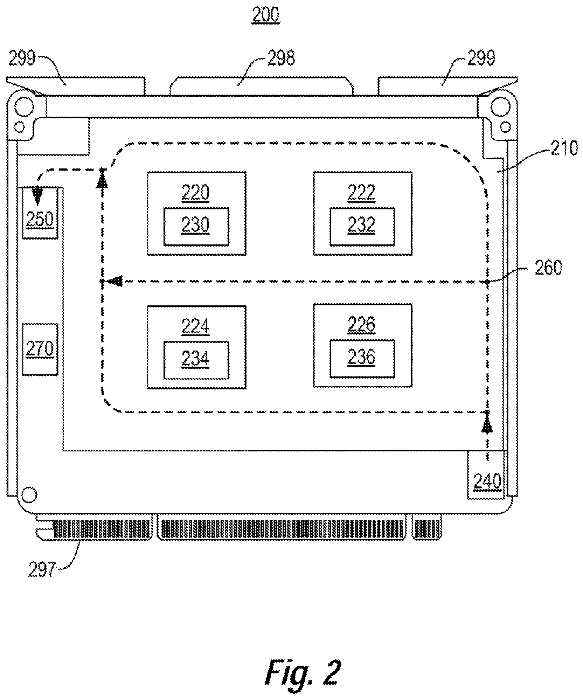

Figure 2 illustrates an example computing cartridge 200 associated with liquid coolant supply. Cartridge 200 includes several elements similar to those described with reference to cartridge 100 (Figure 1 above). For example, Cartridge 200 includes a first electronic device 220 attached via a thermal couple 230 to a cold plate 210. An inlet fluid connector 240 supplies liquid coolant to cold plate 210, and an outlet fluid connector 250 facilitates return of the liquid coolant to cold plate 210. The liquid coolant may flow through cold plate 210 along flow paths 260. Cartridge 200 also includes latches 299, electronic connectors 297, and an interface 298. Cartridge 200 also includes additional elements.

Cartridge 200 also includes several additional electronic devices including second electronic device 222, third electronic device 224, and fourth electronic device 226. These electronic devices are attached to cold plate 210 via thermal couples 232, 234, and 236 respectively. In one example, electronic devices 220, 222, 224, and 226 may be a set of electronic devices configured to optimize performance of a specific application. By way of illustration, if cartridge 200 is designed to serve as a web server, first electronic device 220 may serve as a data store (e.g., hard disk, solid state drive) on which web content is stored, and electronic devices 222, 224, and 226 may be processors that receive and/or respond to incoming requests for system resources.

Cartridge 200 also includes an air-cooled electronic device 270. In one example, air cooled electronic device 270 may consume less power than electronic devices (e.g., 220, 222, 224, 226) which are cooled via cold plate 210.

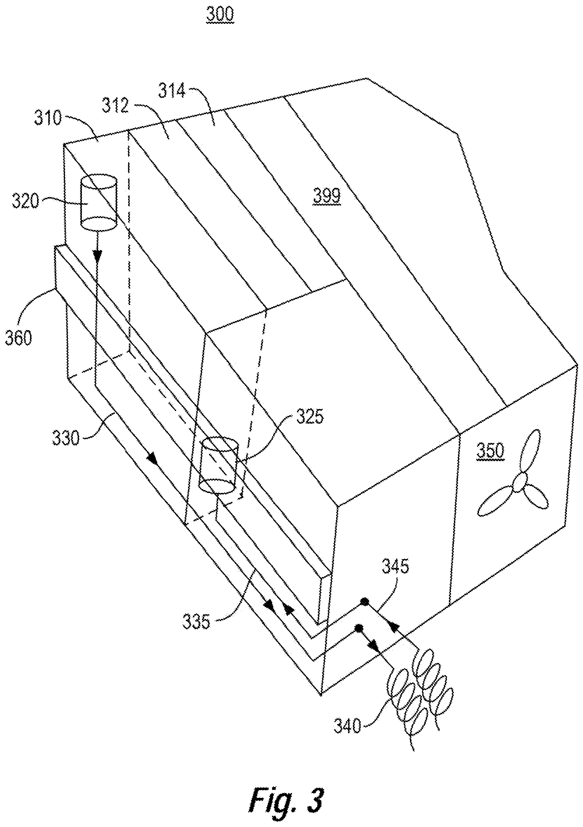

Figure 3 illustrates an example chassis 300 associated with liquid coolant supply. Chassis 300 includes several slots 310, 312, 314 configured to receive top-loading computing cartridges. Though a chassis configured to receive top-loading computing cartridges is illustrated, a chassis may be configured to receive cartridges from other directions. The top-loading computing cartridges may be, for example, cartridges 100 and/or 200 described above in the descriptions of Figures 1 and 2 respectively. Slot 310 includes a supply fluid connector 325. Supply fluid connector 325 may mate with a first fluid connector on a top-loading computing cartridge (e.g., cartridge 100, cartridge 200). Supply fluid connector 325 may be attached to, for example, chassis 300 or to a backplane of chassis 300. Slot 310 also includes a return fluid connector 320. Return fluid connector 320 may mate with a second fluid connector on the top-loading computing cartridge. Return fluid connector 320 may be attached to, for example, chassis 300 or to a backplane of chassis 300. Slots 312 and 314, and other slots (not shown), may also have supply fluid connectors and return fluid connectors (not shown) that facilitate providing liquid coolant to cartridges inserted within their respective slots. In one example, the first fluid connector, the second fluid connector, supply fluid connector 325, and return fluid connector 320 may be blind mate fluid connectors that facilitate hot-plug installment of the top-loading computing cartridge (e.g., cartridge 100, cartridge 200).

Chassis 300 also includes a chassis supply manifold 335 to facilitate supply of liquid coolant to supply fluid connectors (e.g., supply fluid connector 325). Chassis 300 also includes a chassis return manifold 330 to facilitate return of liquid coolant from return fluid connectors (e.g., return fluid connector 320).

In Figure 3, supply fluid connector 325 and return fluid connector 320 are illustrated as connecting to fluid connectors on cartridges (e.g., cartridge 100, cartridge 200) that are at diagonally opposite corners of the cartridge. However, as described above, this is not the only possible configuration of fluid connectors on a cartridge. Consequently, supply fluid connector 325 and return fluid connector 320 may reside at different locations within slot 310, depending on where fluid connectors on cartridges designed to fit within slot 310 reside. Similarly, the locations and/or paths of chassis supply manifold 335 and chassis return manifold 330 may also depend on cartridge design.

Chassis 300 also includes a movable mounting 360. Movable mounting 360 may allow chassis 300 to sit at a retracted position inside a rack structure and at an extend position granting access to the set of slots. In one example, the mountings may operate similarly to rails used in, for example, a kitchen drawer. However, other mountings are possible. Chassis 300 also includes an extending supply hose 345. Extending supply hose 345 may ensure connection of chassis supply manifold 335 to a rack supply manifold associated with the rack structure at both the retracted position and the extended position. Chassis 300 also includes an extending return hose 340. Extending return hose 340 may ensure connection of chassis return manifold 330 to a rack return manifold associated with the rack structure at both the retracted position and the extended position. In one example, extending supply hose 345 and extending return hose 340 may have accordion loop structures.

Chassis 300 also includes a fan 350. Fan 350 may air cool an electronic device on a top-loading computing cartridge (e.g., cartridge 100, cartridge 200) within a slot (e.g., slot 310). In addition to slots (e.g., 310, 312, 314) that house cartridges, chassis 300 also includes a module bay 399. Module bay 399 may serve as a bay for a power distribution unit, a switch, and/or other components depending on the configuration of chassis 300 and/or cartridges residing within chassis 300. A power distribution unit may distribute power to cartridges in their respective slots while the cartridges are operating. A switch may route communications between cartridges within chassis 300, between a cartridge within chassis 300 and cartridges external to chassis 300 (e.g., other cartridges within a rack within which chassis 300 resides), between a cartridge within 300 and a computer over a network (e.g., the Internet, a local area network, a virtual private network), and so forth.

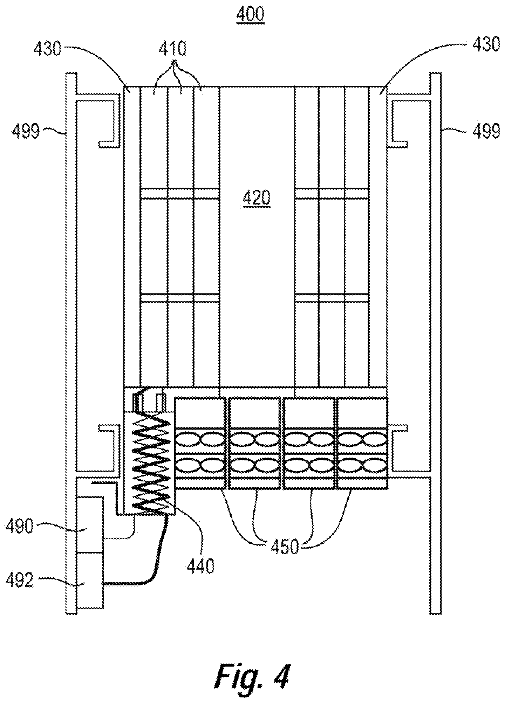

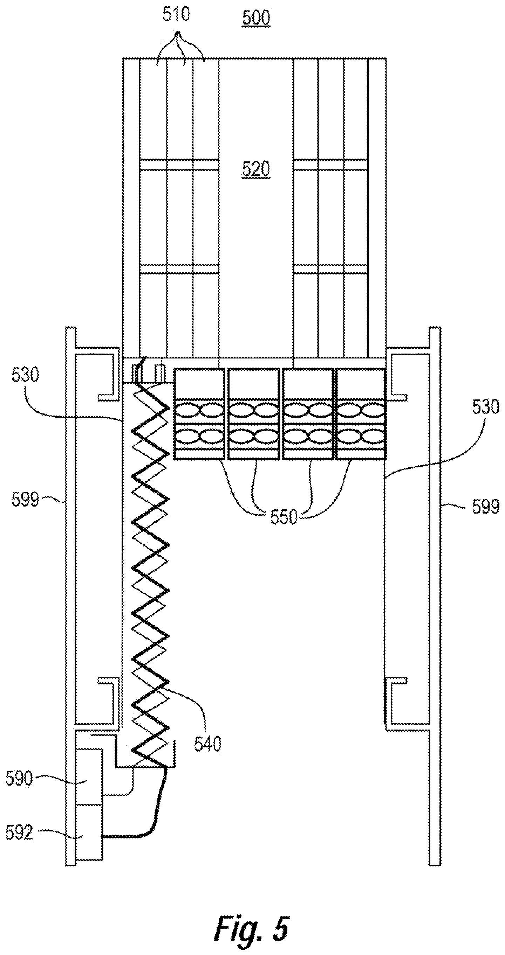

Figure 4 and Figure 5 illustrate further examples of a chassis (400, 500) associated with liquid coolant supply. Specifically, Figures 4 and 5 illustrate how an extending supply hoses (440, 540) and movable mountings (430, 530) may interact to maintain respective connections between supply and return manifolds within the chassis (400, 500) and a rack supply manifold (490, 590) and a rack return manifold (492, 592) associated with a rack (499, 599).

Thus, Figure 4 illustrates a top-down view of a chassis 400 seated at a retracted position within a rack structure 499. Chassis 400 includes several slots 410 in which cartridges (e.g., cartridge 100, cartridge 200) may be seated. The cartridges may be inserted into the slots 410 from above. Chassis 400 also includes a module bay 420 in which other devices may be stored (e.g., a switch). Alternative configurations of chassis 400 may also be possible with different numbers, sizes, and/or positions of cartridge slots 410 and module bay(s) 420.

Chassis 400 also includes movable mountings 430. In this example, chassis 400 and mountings 430 are illustrated at a retracted position. At the retracted position, access to slots 410 and bay 420 may be difficult if several chassis are arranged on top of one another within rack structure 499. Thus, mountings for 430 may allow the chassis to extend out from rack structure 499 (e.g., at a position illustrated in figure 5). This may allow easier access to the slots 410 allowing, for example, cartridges to be removed, inserted, or otherwise manipulated (e.g., for maintenance purposes).

Chassis 400 may also have fluid supply and return manifolds (not shown) that facilitate transfer of liquid coolant to and from devices inserted into slots 410 and/or bay 420. To ensure connection of the chassis supply manifold to a rack supply manifold 490, and the chassis return manifold to a rack return manifold 492, chassis 400 may also have extendable hoses 440 to connect the respective manifolds. In one example, at the retracted position of chassis 400 within rack structure 499, the extendable hoses 440 may essentially reside within the structure of chassis 400. In some circumstances however, it may be appropriate for the hoses 440 to sit outside of chassis 400. Chassis 400 also includes several fans 450 which may serve to air cool electrical components (e.g., on cartridges within slots 410).

Figure 5 illustrates an example chassis 500. Chassis 500 includes several components similar to those described with reference to chassis 400 (Figure 4 above). For example, chassis 500, which sits within a rack structure 599, includes several slots 510, a bay 520, and several fans 550. Chassis 500 also includes movable mountings 530, which are shown as being in an extended position allowing access to slots 510 and bay 520. Because chassis 500 at the extended position is farther away from rack supply manifold 590 and from rack return manifold 592, extendable hoses 540 extend to maintain respective connection between fluid supply and return manifolds within chassis 500 and rack supply manifold 590 and rack supply manifold 592.

Because the supply (and return) of liquid coolant is facilitated by extendable hoses 540, cartridges within slots 510 may be able to continue receiving cooling even though other cartridges are being manipulated (e.g., inserted, removed, serviced).

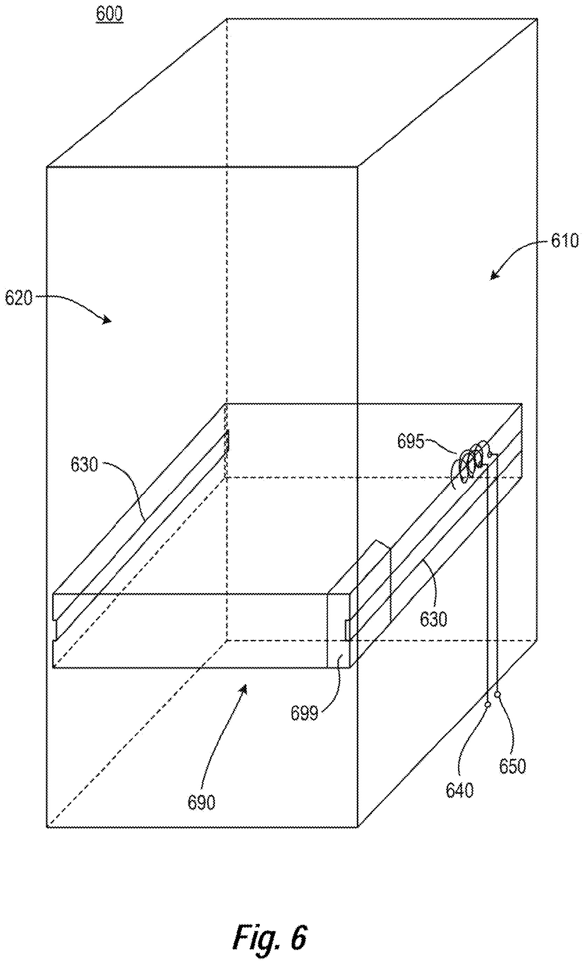

Figure 6 illustrates an example rack system 600 associated with liquid coolant supply. Rack system 600 includes an enclosure having first wall 610 and a second wall 620. Within the enclosure of rack system 600 may be one or more chassis 690. Chassis 690 may include several slots 699 in which computing cartridges may reside. The cartridges may be similar to cartridges 100 and 200 (described above in Figures 1 and 2 respectively). Thus the cartridges may have electronic devices which are cooled by liquid cooling techniques. To ensure liquid coolant transfer to and from a cartridge sitting within slot 699, chassis 690 may transfer liquid coolant along chassis supply and return manifolds (not shown). Chassis 690 may be seated on movable mountings 630, which may allow chassis 690 to sit retracted within rack structure 600 or extended out from rack structure 600, allowing access to slots (e.g., slot 699) within chassis 690.

Rack system 600 includes a fluid supply manifold 640 to facilitate supply of a liquid coolant to chassis 690. Similarly, rack system 600 includes a fluid return manifold 650 to facilitate return of the liquid coolant from the chassis. In one example, fluid supply manifold 640 and fluid return manifold 650 may permit unobstructed air flow to the chassis. Further, fluid supply manifold 640 and fluid return manifold 650 may be held separate from a signal line (not shown) that provides signal to the chassis (e.g., Ethernet) and/or a power line (not shown) that provides power to the chassis. In this example, fluid supply manifold 640 and fluid return manifold 650 may be affixed to first wall 610. However, different configurations may be appropriate.

Because chassis 690 may sit retracted within rack structure 600 and extended out from rack structure 600, rack system 600 also includes fluid supply and return hoses 695 to maintain respective connections between chassis supply and return manifolds within chassis 690, and supply manifold 640 and return manifold 650. Supply manifold 640 and return manifold 650 may also be attached to plumbing (e.g., pipes, hoses) in a data center within which rack structure 600 resides.

It is appreciated that the previous description of the disclosed examples is provided to enable any person skilled in the art to make or use the present disclosure. Various modifications to these examples will be readily apparent to those skilled in the art, and the generic principles defined herein may be applied to other examples without departing from the scope of the disclosure as claimed.

## Claims

1. A computing cartridge (100), comprising:
a first electronic device (120);
a liquid-cooled cold plate (110);
a first thermal couple (130) between the first electronic device (120) and the cold plate (110);
a hot plug capable blind mate inlet fluid connector (140) to facilitate supply of a liquid coolant to a plurality of fluid channels contained within the cold plate (110); and
a hot plug capable blind mate outlet fluid connector (150) to facilitate return of the liquid coolant from the cold plate (110) wherein the liquid coolant returns upon passage through the plurality of fluid channels; and **characterized in that**:
the inlet fluid connector (140) is located at the first corner of the cold plate (110) and the outlet fluid connector (150) is located at a second, diagonally opposite corner of the cold plate (150),
where the computing cartridge (100) is a top-loading computing cartridge.

2. The computing cartridge (100) of claim 1, comprising:
a second electronic device (222); and
a second thermal couple (232) between the second electronic device (222) and the cold plate (110).

3. The computing cartridge (100) of claim 1, comprising an air cooled electronic device (270).

4. The computing cartridge (100) of claim 1, where the first electronic device (120) is a member of a set of electronic devices on the computing cartridge (100), and where the set of electronic devices optimize performance of a specific application.

5. A chassis (300), comprising:
a set of slots (310, 312, 314) configured to receive computing cartridges;
the computing cartridge (100) of any preceding claim, the computing cartridge (100) being seated in a first slot (310) of the set of slots (310, 312, 314), wherein the first slot (310) comprises:
a supply fluid connector (325) that mates with the inlet fluid connector (140) on the computing cartridge (100); and
a return fluid connector (320) that mates with the outlet fluid connector (150) on the computing cartridge (100);
a movable mounting (360) allowing the chassis (300) to sit at a retracted position inside a rack structure and at an extended position granting access to the set of slots (310, 312, 314);
a chassis supply manifold (335) to facilitate supply of a liquid coolant to the supply fluid connector (325);
a chassis return manifold (330) to facilitate return of the liquid coolant from the return fluid connector (320);
an extending supply hose (345) to ensure connection, at both the retracted position and the extended position, of the chassis supply manifold (335) to a rack supply manifold associated with the rack structure; and
an extending return hose (340) to ensure connection, at both the retracted position and the extended position, of the chassis return manifold (330) to a rack return manifold associated with the rack structure.

6. The chassis of claim 5, where the extending supply hose (345) has an accordion loop structure and where the extending return hose (340) has an accordion loop structure.

7. The chassis of claim 5, where the supply fluid connector (325) is attached to one of the chassis (300) and a backplane of the chassis (300), and where the return fluid connector (320) is attached to one of the chassis (300) and the backplane of the chassis (300).

8. The chassis of claim 5, comprising a fan (350) to air cool an electronic device on the computing cartridge (100).

9. A rack system (600), comprising:
an enclosure having a first wall (610) and a second wall (620);
a chassis (300) according to any of claims 5 to 8, the chassis (300) being mounted between the first wall (610) and the second wall (620);
a fluid supply manifold (640) to facilitate supply of a liquid coolant to the chassis (300); and
a fluid return manifold (650) to facilitate return of the liquid coolant from the chassis (300) ;
where the fluid supply manifold (640) and the fluid return manifold (650) permit unobstructed air flow to the chassis (300), and where the fluid supply manifold (640) and the fluid return manifold (650) are held separate from one or more of: a signal line providing signal to the chassis, and a power line providing power to the chassis.

10. The rack system (600) of claim 9, where the chassis (300) is movably mounted within the enclosure.

11. The rack system (600) of claim 9, where the fluid supply manifold (640) and the fluid return manifold (650) are affixed to the first wall (610).

## Patentansprüche

1. Computerkartusche (100), die Folgendes umfasst:
eine erste elektronische Vorrichtung (120);
eine flüssigkeitsgekühlte Kühlplatte (110);
ein erstes Wärmepaar (130) zwischen der ersten elektronischen Vorrichtung (120) und der Kühlplatte (110);
einen hot-plug-fähigen Blindmate-Einlassfluidanschluss (140), um eine Zufuhr eines flüssigen Kühlmittels zu mehreren Fluidkanälen, die innerhalb der Kühlplatte (110) enthalten sind, zu erleichtern; und
einen hot-plug-fähigen Blindmate-Auslassfluidanschluss (150), um eine Rückführung des flüssigen Kühlmittels von der Kühlplatte (110) zu erleichtern, wobei das flüssige Kühlmittel beim Durchgang durch die mehreren Fluidkanäle zurückkehrt; und **dadurch gekennzeichnet, dass**:
der Einlassfluidanschluss (140) sich an der ersten Ecke der Kühlplatte (110) befindet und der Auslassfluidanschluss (150) sich an einer zweiten, diagonal gegenüberliegenden Ecke der Kühlplatte (150) befindet,
wobei die Computerkartusche (100) eine von oben zu ladende Computerkartusche ist.

2. Computerkartusche (100) nach Anspruch 1, die Folgendes umfasst:
eine zweite elektronische Vorrichtung (222); und
ein zweites Wärmepaar (232) zwischen der zweiten elektronischen Vorrichtung (222) und der Kühlplatte (110).

3. Computerkartusche (100) nach Anspruch 1, die eine luftgekühlte elektronische Vorrichtung (270) umfasst.

4. Computerkartusche (100) nach Anspruch 1, wobei die erste elektronische Vorrichtung (120) ein Element eines Satzes elektronischer Vorrichtungen auf der Computerkartusche (100) ist, und wobei der Satz elektronischer Vorrichtungen die Leistung einer spezifischen Anwendung optimiert.

5. Chassis (300), das Folgendes umfasst:
einen Satz von Schlitzen (310, 312, 314), die dazu konfiguriert sind, Computerkartuschen aufzunehmen;
die Computerkartusche (100) nach einem der vorhergehenden Ansprüche, wobei die Computerkartusche (100) in einem ersten Schlitz (310) des Satzes von Schlitzen (310, 312, 314) eingesetzt ist, wobei der erste Schlitz (310) Folgendes umfasst:
einen Zufuhrfluidanschluss (325), der mit dem Einlassfluidanschluss (140) an der Computerkartusche (100) zusammenpasst; und
einen Rückführfluidanschluss (320), der mit dem Auslassfluidanschluss (150) an der Computerkartusche (100) zusammenpasst;
eine bewegliche Halterung (360), die es dem Chassis (300) ermöglicht, in einer eingefahrenen Position innerhalb einer Regalstruktur und in einer ausgefahrenen Position zu sitzen, die Zugriff auf den Satz von Schlitzen (310, 312, 314) gewährt;
einen Chassis-Zufuhrverteiler (335), um die Zufuhr eines flüssigen Kühlmittels zu dem Zufuhrfluidanschluss (325) zu erleichtern;
einen Chassis-Rückführverteiler (330), um die Rückführung des flüssigen Kühlmittels aus dem Rückführfluidanschluss (320) zu erleichtern;
einen ausfahrbaren Zufuhrschlauch (345), um sowohl in der eingefahrenen als auch in der ausgefahrenen Position den Anschluss des Chassis-Zufuhrverteilers (335) an einen der Regalstruktur zugeordneten Regal-Zufuhrverteiler sicherzustellen; und
einen ausfahrbaren Rückführschlauch (340), um sowohl in der eingefahrenen als auch in der ausgefahrenen Position den Anschluss des Chassis-Rückführverteilers (330) an einen der Regalstruktur zugeordneten Regal-Rückführverteiler sicherzustellen.

6. Chassis nach Anspruch 5, wobei der ausfahrbare Zufuhrschlauch (345) eine Ziehharmonikaschleifenstruktur aufweist und wobei der ausfahrbare Rückführschlauch (340) eine Ziehharmonikaschleifenstruktur aufweist.

7. Chassis nach Anspruch 5, wobei der Zufuhrfluidanschluss (325) an dem Chassis (300) oder einer Rückwandplatine des Chassis (300) angebracht ist, und wobei der Rückführfluidanschluss (320) an dem Chassis (300) oder der Rückwandplatine des Chassis (300) angebracht ist.

8. Chassis nach Anspruch 5, das einen Lüfter (350) umfasst, um eine elektronische Vorrichtung auf der Computerkartusche (100) luftzukühlen.

9. Regalsystem (600), das Folgendes umfasst:
ein Gehäuse, das eine erste Wand (610) und eine zweite Wand (620) aufweist;
ein Chassis (300) nach einem der Ansprüche 5 bis 8, wobei das Chassis (300) zwischen der ersten Wand (610) und der zweiten Wand (620) montiert ist;
einen Fluidzufuhrverteiler (640), um die Zufuhr eines flüssigen Kühlmittels zu dem Chassis (300) zu erleichtern; und
einen Fluidrückführverteiler (650), um die Rückführung des flüssigen Kühlmittels aus dem Chassis (300) zu erleichtern;
wobei der Fluidzufuhrverteiler (640) und der Fluidrückführverteiler (650) einen ungehinderten Luftstrom zu dem Chassis (300) ermöglichen, und wobei der Fluidzufuhrverteiler (640) und der Fluidrückführverteiler (650) von Folgendem getrennt gehalten werden: einer Signalleitung, die Signale an das Chassis bereitstellt, und/oder einer Stromleitung, die Strom an das Chassis bereitstellt.

10. Regalsystem (600) nach Anspruch 9, wobei das Chassis (300) innerhalb des Gehäuses beweglich montiert ist.

11. Regalsystem (600) nach Anspruch 9, wobei der Fluidzufuhrverteiler (640) und der Fluidrückführverteiler (650) an der ersten Wand (610) befestigt sind.

## Revendications

1. Cartouche informatique (100), comprenant :
un premier dispositif électronique (120) ;
une plaque froide (110) refroidie par liquide ;
un premier couple thermique (130) entre le premier dispositif électronique (120) et la plaque froide (110) ;
un raccord de fluide d'entrée en aveugle pouvant être raccordé à chaud (140) pour faciliter l'alimentation d'un réfrigérant liquide à une pluralité de canaux de fluide contenus à l'intérieur de la plaque froide (110) ; et
un raccord de fluide de sortie en aveugle pouvant être raccordé à chaud (150) pour faciliter le retour du réfrigérant liquide de la plaque froide (110) dans lequel le réfrigérant liquide retourne lors de son passage à travers la pluralité de canaux de fluide ; et **caractérisé en ce que** :
le raccord d'entrée de fluide (140) est situé au premier coin de la plaque froide (110) et le raccord de sortie de fluide (150) est situé au niveau d'un second coin diagonalement opposé de la plaque froide (150),
où la cartouche informatique (100) est une cartouche informatique à chargement par le haut.

2. Cartouche informatique (100) selon la revendication 1, comprenant :
un second dispositif électronique (222) ; et
un second couple thermique (232) entre le second dispositif électronique (222) et la plaque froide (110).

3. Cartouche informatique (100) selon la revendication 1, comprenant un dispositif électronique refroidi par air (270).

4. Cartouche informatique (100) selon la revendication 1, où le premier dispositif électronique (120) est un élément d'un ensemble de dispositifs électroniques sur la cartouche informatique (100) un dispositif d'affichage, et où l'ensemble de dispositifs électroniques optimisent la performance d'une application spécifique.

5. Châssis (300) comprenant :
un ensemble de fentes (310, 312, 314) conçues pour recevoir des cartouches informatiques ;
la cartouche informatique (100) selon l'une quelconque des revendications précédentes, la cartouche informatique (100) étant placée dans une première fente (310) de l'ensemble de fentes (310, 312, 314), la première fente (310) comprenant :
un raccord d'alimentation en fluide (325) qui s'accouple avec le raccord de fluide d'entrée (140) sur la cartouche informatique (100) ; et
un raccord de retour de fluide (320) qui s'accouple avec le raccord de sortie de fluide (150) sur la cartouche informatique (100) ;
un support mobile (360) permettant au châssis (300) de reposer en une position rétractée à l'intérieur d'une structure de bâti et en une position déployée permettant d'accéder à l'ensemble de fentes (310, 312, 314) ;
un collecteur d'alimentation de châssis (335) pour faciliter l'alimentation d'un réfrigérant liquide au raccord de fluide d'alimentation (325) ;
un collecteur de retour de châssis (330) pour faciliter le retour du réfrigérant liquide depuis le raccord de retour de fluide (320) ;
un tuyau d'alimentation en extension (345) pour assurer le raccordement, à la fois en position rétractée et en position déployée, du collecteur d'alimentation de châssis (335) à un collecteur d'alimentation de bâti associé à la structure de bâti ; et
un tuyau de retour en extension (340) pour assurer le raccordement, à la fois en position rétractée et en position déployée, du collecteur de retour de châssis (330) à un collecteur de retour de bâti associé à la structure de bâti.

6. Châssis selon la revendication 5, où le tuyau d'alimentation en extension (345) a une structure de boucle en accordéon et où le tuyau de retour en extension (340) a une structure de boucle en accordéon.

7. Châssis selon la revendication 5, le raccord de fluide d'alimentation (325) étant fixé à l'un parmi le châssis (300) et une face arrière du châssis (300), et où le raccord de retour de fluide (320) est fixé à l'un parmi le châssis (300) et la face arrière du châssis (300).

8. Châssis selon la revendication 5, comprenant un ventilateur (350) pour refroidir à l'air un dispositif électronique sur la cartouche informatique (100).

9. Système de bâti (600), comprenant :
un boîtier présentant une première paroi (610) latérale et une seconde paroi (620) latérale ;
un châssis (300) selon l'une quelconque des revendications 5 à 8, le châssis (300) étant monté entre la première paroi (610) et la seconde paroi (620) ;
un collecteur d'alimentation en fluide (640) pour faciliter l'alimentation en réfrigérant liquide du châssis (300) ; et
un collecteur de retour de fluide (650) pour faciliter le retour du réfrigérant liquide provenant du châssis (300) ;
où le collecteur d'alimentation en fluide (640) et le collecteur de retour de fluide (650) permettent un écoulement d'air sans obstruction vers le châssis (300), et où le collecteur d'alimentation en fluide (640) et le collecteur de retour de fluide (650) sont maintenus séparés : d'une ligne de signal fournissant un signal au châssis, et/ou d'une ligne d'alimentation fournissant l'alimentation au châssis.

10. Système de bâti (600) selon la revendication 9, où le châssis (300) est monté de manière mobile à l'intérieur du boîtier.

11. Système de bâti (600) selon la revendication 9, le collecteur d'alimentation en fluide (640) et le collecteur de retour de fluide (650) étant fixés à la première paroi (610).
